(19) Europäisches Patentamt / European Patent Office / Office européen des brevets

(11) **EP 2 024 755 B1**

(12) **EUROPEAN PATENT SPECIFICATION**

(45) Date of publication and mention
of the grant of the patent:
**29.12.2010   Bulletin 2010/52**

(51) Int Cl.:
*G01R 31/28* *(2006.01)*     *G01R 31/34* *(2006.01)*
*G01R 27/28* *(2006.01)*     *G01R 31/06* *(2006.01)*

(21) Application number: **06741628.9**

(22) Date of filing: **07.06.2006**

(86) International application number:
**PCT/CH2006/000303**

(87) International publication number:
**WO 2007/140627 (13.12.2007 Gazette 2007/50)**

(54) **A METHOD FOR DETERMINING THE LINEAR ELECTRICAL RESPONSE OF A TRANSFORMER, GENERATOR OR ELECTRICAL MOTOR**

VERFAHREN ZUM BESTIMMEN DES LINEAREN ELEKTRISCHEN ANSPRECHVERHALTENS EINES TRANSFORMATORS, GENERATORS ODER ELEKTROMOTORS

PROCÉDÉ PERMETTANT DE DÉTERMINER LA RÉPONSE ÉLECTRIQUE LINÉAIRE D'UN TRANSFORMATEUR, GÉNÉRATEUR OU MOTEUR ÉLECTRIQUE

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**18.02.2009   Bulletin 2009/08**

(73) Proprietor: **ABB Technology AG**
**8050 Zürich (CH)**

(72) Inventors:
• **TIBERG, Martin**
  **1202 Genéve (CH)**
• **HEITZ, Christoph**
  **8353 Elgg (CH)**
• **HOENECKER, Olaf**
  **8400 Winterthur (CH)**
• **GUSTAVSEN, Bjorn**
  **7465 Trondheim (NO)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(56) References cited:
**WO-A-01/84169        GB-A- 2 411 733**
**US-A- 4 156 842        US-A- 5 396 172**
**US-A- 6 035 265        US-A1- 2004 164 745**

• **KEYHANI A ET AL: "Identification of high-order synchronous generator models from SSFR test data" IEEE TRANSACTIONS ON ENERGY CONVERSION USA, vol. 9, no. 3, September 1994 (1994-09), pages 593-603, XP002423038 ISSN: 0885-8969**

**Description**

Technical field

The invention relates to a method for determining the linear electrical response of a transformer, generator or electrical motor as well as to a use of such a method.

Background

There are various methods to characterise the linear electrical response of transformers, generators or electrical motors. Typically, they include a measurement step under a certain terminal configuration, where the terminals of the component are connected to defined voltage or current sources or impedances or interconnected with each other. Some terminals may also be left unconnected (i.e. connected to an impedance of infinite value). Then, a measurement is carried out, e.g. by determining the voltage at one terminal as a function of the voltage at another terminal.

A typical such technique is the Frequency Response Analysis (FRA), which has evolved as a transformer diagnostic technique for quality control and detection of internal faults, which may not otherwise be detected without opening the transformer and inspecting it by hand and eye. Opening a transformer and emptying the oil therein is very costly and takes long time, whereas FRA is relatively cheap and done within less than one day.

A FRA measurement consists of applying a voltage on one terminal of the transformer (the source terminal) and measuring the voltage output on one of the others (the sink terminal) for a large range of frequencies. The other terminals, which are not source or sink, can either be grounded or left open.

The diagnosis is carried out by studying how the voltage ratio between sink and source varies over the frequency range, and comparing these variations between the phases to check for asymmetries and/or comparing these variations to older records of the same or similar transformers to check for changes over time.

There is no standard specifying exactly how FRA measurements shall be done, even though groups both within IEEE and CIGRE work on such standardisation. Typically, the voltage ratio and sometimes the phase between a source and sink terminal is measured. The number of possible terminal configurations is very large because of the variations in the following parameters:

- Type of transformer,
- Number of terminals on transformer,
- Having the unused terminals open or grounded.

A typical delta-star or star-delta 2-winding transformer has seven terminals: 3 on the HV side, 3 on the LV side and one neutral point. Each of these 7 terminals can be the source terminal and any of the other 6 can be the sink terminal resulting in 42 different combinations and possible measurements. Having the unused terminals both open and grounded doubles the number of measurements. Extra terminals or special configurations, such as having some terminals open and some closed, multiplies the number of measurements further.

This large number of possible terminal configurations make a full characterisation of the component cumbersome if not impossible by standard FRA. Therefore, typically, only a subset of the possible terminal configurations are measured, e.g.:

- 3 on the delta side; connect any two terminals to measure over each winding,
- 3 on the star side; measure between neutral and each terminal,
- 3 between HV and LV side for each phase.

These nine measurements often give a good picture of the winding conditions, such that an assessment can be made of the transformer condition. However, there are several important shortcomings of this kind of measurements:

1. It still takes a significant amount of time to reconnect nine times.
2. It happens easily that measurement errors are made when reconnecting. The contact resistance can vary greatly depending on how well the measurement cables are connected to the transformer terminals. Changing the position of the cables between two reconnections can significantly impact the measurement response in the high frequency range.
3. The measurement is incomplete. From just the LV-HV measurements per each phase, you do not see the coupling between the phases, which may reveal important information.
4. Most commercial FRA measurement equipment has 50 Ohm impedance both on the source and sink channel, which is added in series to the transformer measurement and damps the response for low impedances. Thus, impedance variations between say 1-3 Ohm may hardly be seen due to the 50 Ohm impedance in series.

5. Each of the 9. measurements is performed on a different state of the transformer. Consequently, the terminals are alternatively open or terminated with 50 Ohm, which completely changes the transformer state. Even if all non-measured terminals are grounded, the termination is still changed from ground to 50 Ohm on some terminals between each measurement, which invalidates advanced analysis and modeling that assumes that the transformer is a constant well-defined system.

Further state of the art

From US 4,156,842 a system for measuring the transfer immitances, impendance and admittance, of a linear electrical network having one or more ports is known. The system utilizes clamp-on ferromagnetic cores to electromagnetically couple the transfer immitance measuring system to the electrical network without havin to interrupt the normal on-line operation of the electrical network.

GB 2 411 733 discribes a method for characterizing a three phase transformer using a single phase power supply.

IEEE Transcactions on Energhy Conversion, Vol. 9, No. 3, September 1994, page 593ff, discloses a direct maximum-likelihood estimation procedure to identify the synchronous machine models based on the standstill frequendcy response test data.

Summary of the invention

Hence, it is an object to provide a method, which allows to determine the linear response of a transformer, generator or electrical motor having several terminals, i.e. at least two terminals, in particular at least three terminals, under a given test terminal configuration. The method should have improved ease of use and/or reliability.

This object is achieved by the method according to claim 1.

Accordingly, in a first step a), a set of terminal configurations are applied to the terminals of the component in order to obtain data describing the linear electrical response of the component to any pattern of voltages or currents applied to the terminals. Such data is e.g. expressed in terms of an admittance or impedance matrix or, advantageously, by a set of current and voltage vector pairs as described below.

Using this data, the linear electrical response of the component under the test terminal configuration can now be calculated in a second step b).

This procedure has the advantage that no actual measurement under the test terminal configuration is required. Rather, the measurement can take place under any suitable set of terminal configurations, which allows to choose the most suitable measurement process at hand.

Advantageously, the same data can be used to calculate the response of the component to a plurality of different test configurations.

In a further advantageous embodiment, a measuring device is connected simultaneously to all terminals of the component. The measuring device is adapted to generate the set of terminal configurations and to measure the response of the component to each of these terminal configurations. For example, the measuring device may be equipped to apply different values of voltages, currents and/or impedances to each terminal. This allows to generate the set of terminal configurations without the need to change the cables attached to the component, which increases the accuracy of the measurement.

In particular, such a measuring device can be operated automatically, which allows to increase the measurement speed and reliability.

Advantageously, the linear electrical response at the test terminal configuration is calculated as the ratio and/or phase shift between two voltages at different terminals, in particular as a function of frequency. This type of information is used in the so-called frequency response analysis (FRA), which is applied when assessing the status or ageing of a transformer. The present method allows to carry out FRA even if no direct measurement of the ratio and/or phase shift between two voltages at different terminals was made.

A particularly advantageous implementation of step a) comprises an "estimation procedure" in which an esti-mated admittance matrix $\mathbf{Y'}$ is determined by applying voltages to the terminals of the component and measuring the response of the component. The estimation procedure can e.g. consist of a conventional measurement of the admittance matrix $\mathbf{Y'}$ by applying a voltage to one terminal, grounding all other terminals, measuring the current at each terminal, and repeating this procedure for all terminals. The estimation procedure is followed by a "measurement procedure", in which several voltage patterns $u_k$ are applied to the terminals. The voltage patterns correspond to the eigenvectors $\mathbf{v}_k$ of the estimated admittance matrix $\mathbf{Y'}$, wherein "correspond" is to express that the pattern $u_k$ is substantially (but not necessarily exactly) parallel to the (normalised) eigenvector $v_k$ corresponding to each eigenvalue $\lambda_k$. For each applied voltage pattern $u_k$, the response of the component is measured.

As it has been found, applying voltage patterns $u_k$ corresponding to the eigenvectors $v_k$ of the admittance matrix Y' allows to obtain a more accurate description of the component, especially when the eigenvalues $\lambda_k$ of the admittance matrix Y' differ substantially from each other.

The invention is particularly useful for high-voltage or medium-voltage components, i.e. for components suited for operation at voltages exceeding 1 kV.

The method can e.g. be used for characterising the electrical component. In order to do so, a reference can be provided, e.g. measured at an earlier time (prior to step a) or measured on a reference component, which reference describes the response (the "first response") of the component under a given test terminal configuration. A measurement according to the present method is then carried out to determine the actual state of the component, and the data from this measurement is used to calculate a "second response" of the component under the test terminal configuration. The first and the second response are then compared for checking the actual status of the component.

Brief description of the drawings

Further embodiments, advantages and applications of the invention are disclosed in the dependent claims as well as in the following description, which makes reference to the figures, wherein:

Fig. 1 is an example of a transformer to be characterised by the present method,
Fig. 2 shows the component of Fig. 1 connected to a measuring device,
Fig. 3 is a schematic illustration of a component to be characterised,
Fig. 4 is a block circuit diagram of a first embodiment of a device for a measuring device for characterising the component,
Fig. 5 is a second embodiment of a measuring device, and
Fig. 6 is a third embodiment of a measuring device.

Embodiments of the invention

1. Definitions:

The term "terminal configuration" refers to a defined state of all terminals of the component. The state of a terminal $k$ can be defined by

- the current $i_k$ that is flowing through it ($i_k = 0$ corresponds to an open terminal) or
- the voltage $u_k$ that is applied to it ($u_k = 0$ corresponds to a grounded terminal) or
- the impedance $Z_k$ and a voltage $\varphi_k$ of a voltage source that are connected in series to it, or
- the index $m$ of another terminal that the given terminal $k$ is connected to (or a series of indices $m_1$, $m_2$, ..., if terminal $k$ is connected to several other terminals).

2. A first example:

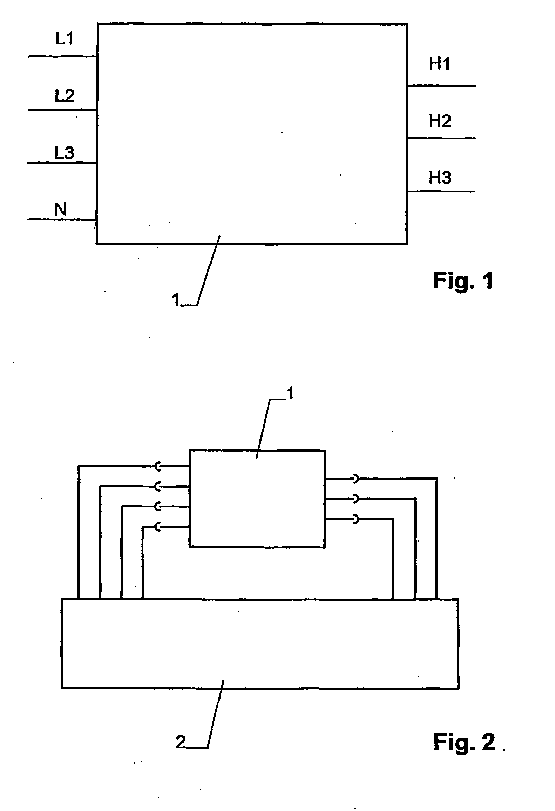

To illustrate the present invention, an example thereof is described in the following. This example relates to the characterisation and, in particular, to the quality control of a transformer 1 as it is e.g. shown in Fig. 1.

The transformer 1 of Fig. 1 is of the star-delta configuration and has $n = 7$ terminals L1, L2, L3, N, H1, H2, H3.

To characterise transformer 1, a two-step procedure is carried out, namely a measurement step a) and a calculation step b).

In measurement step a) all seven terminals L1, L2, L3, N, H1, H2, H3 of transformer 1 are connected to a measuring device 2 as shown in Fig. 2. Measuring device 2 comprises, for each terminal L1, L2, L3, N, H1, H2, H3, an adjustable voltage source and/or an adjustable current source and/or an adjustable impedance. Measuring device 2 automatically applies a set of terminal configurations to transformer 1 by repetitively adjusting the voltage sources, current sources and/or impedances. For each terminal configuration, the response of transformer 1 is measured, e.g. by measuring the voltages and currents at all terminals L1, L2, L3, N, H1, H2, H3. In a simplest embodiment, $n$ different terminal configurations are applied, e.g. by applying n different, linearly independent voltage vectors $\mathbf{u}_i$ ($i = 1 ... n$) and measuring the corresponding current vectors $\mathbf{i}_i$ ($i = 1 ... n$). Each such voltage vector $u_i$ has $n$ elements ($u_{1i}, ... u_{ni}$), and each current vector $\mathbf{i}_i$ has $n$ elements ($i_{1i}, ... i_{ni}$) indicating the voltage $u_{ki}$ and current $i_{ki}$ at terminal $k$ in terminal configuration $i$. The knowledge of the vectors $u_i$ and $i_i$ for the $n$ terminal configurations allows to estimate the admittance matrix **Y** from a set of n vector equations

$$i_i = Y \cdot u_i \qquad (1)$$

The measurements are carried out as a function of frequency.

It must be noted though that this type of measurement yields inaccurate results only, and a more refined measurement method is described in the section "improved measurement method" below.

In general, the result of measurement step a) is data describing the linear electrical response of the component 1 (such as transformer 1) to any pattern of voltages or currents applied to the terminals L1, L2, L3, N, H1, H2, H3. This data can e.g. be expressed by the admittance matrix Y, the corresponding impedance matrix Z, or by $n$ linearly independent current and voltage vector pairs, each pair describing the voltages and corresponding currents at all terminals L1, L2, L3, N, H1, H2, H3. For reasons explained under the section "improved measurement method" below, the $n$ linearly independent current and voltage vector pairs is considered to be the most advantageous representation of the data.

In the calculation step b) following measuring step a) the linear electrical response of transformer 1 is calculated for a given test terminal configuration. In general, this test terminal configuration will not be among the set of terminal configurations used in step a) for measuring the component.

For example, when FRA is to be carried out on transformer 1, the test configuration will be a configuration where all except two terminals are grounded (or open). The two terminals are assumed to be terminated by known impedances, such as 50 Ohm. A voltage is applied to one of the two terminals, while the voltage at the other terminal is measured. In other words, the test terminal configuration corresponds to a typical FRA measurement terminal configuration. However, instead of carrying out an actual measurement at the test terminal configuration, the result of such a measurement is simulated by calculating the component's behavior from the data obtained in step a).

The calculated result can then e.g. be used to determine the ratio and/or voltage phase difference between two terminals as a function of frequency to obtain a graph as used in FRA.

For example, to calculate the response of an FRA measurement, where the first terminal (e.g. L1 in Fig. 1) is the source, the fourth terminal (e.g. H1 in Fig. 1) is the sink, and all the other terminals L2, L3, N, H2, H3 are open, and the first and fourth terminal are terminated with a $R_1 = R_4 = 50$ Ohm impedance, the current vector i is given by

$$i = \begin{pmatrix} i_1 \\ 0 \\ 0 \\ -u_4/R_4 \\ 0 \\ 0 \end{pmatrix} \qquad (2)$$

The FRA response $u_4/u_1$ is straight-forward to calculate from the relationship

$$\begin{pmatrix} i_1 \\ 0 \\ 0 \\ -u_4/R_4 \\ 0 \\ 0 \\ 0 \end{pmatrix} = \begin{pmatrix} Y_{11} & Y_{12} & \cdot\cdot & \cdot\cdot & \cdot\cdot & \cdot\cdot & \cdot\cdot \\ Y_{21} & \cdot\cdot & \cdot\cdot & \cdot\cdot & \cdot\cdot & \cdot\cdot & \cdot\cdot \\ \cdot\cdot & \cdot\cdot & \cdot\cdot & \cdot\cdot & \cdot\cdot & \cdot\cdot & \cdot\cdot \\ \cdot\cdot & \cdot\cdot & \cdot\cdot & \cdot\cdot & \cdot\cdot & \cdot\cdot & \cdot\cdot \\ \cdot\cdot & \cdot\cdot & \cdot\cdot & \cdot\cdot & \cdot\cdot & \cdot\cdot & \cdot\cdot \\ \cdot\cdot & \cdot\cdot & \cdot\cdot & \cdot\cdot & \cdot\cdot & \cdot\cdot & \cdot\cdot \\ \cdot\cdot & \cdot\cdot & \cdot\cdot & \cdot\cdot & \cdot\cdot & \cdot\cdot & Y_{77} \end{pmatrix} \begin{pmatrix} u_1 \\ \cdot\cdot \\ \cdot\cdot \\ u_4 \\ \cdot\cdot \\ \cdot\cdot \\ \cdot\cdot \end{pmatrix}, \qquad (3)$$

with $Y_{ij}$ being components of the admittance matrix Y.

The easiest way to proceed is to multiply both sides of the equation (3) with the impedance matrix $Z = Y^{-1}$ and

then to reduce the system of equations to just the first and fourth row. Then there are three unknowns, $u_1$, $u_4$ and $i_1$, and two equations. Since we are interested in the complex ratio $u_4/u_1$ (i.e. ratio of the voltage amplitudes as well as their mutual phase shift), the unknowns are further reduced to two, and we get the following result:

$$\frac{u_4}{u_1} = \frac{R_4 \cdot z_{41}}{z_{11}(z_{44} + R_4) - z_{41}z_{14}}, \qquad (4)$$

with $z_{ij}$ being the components of the impedance matrix Z.

If the same FRA with the unused terminals L2, L3, N, H2, H3 being grounded instead of being open were to be calculated, their terminal configurations would just change from $i_x = 0$ to $u_x = 0$, yielding the expression

$$\frac{u_4}{u_1} = -\frac{R_4 \cdot y_{41}}{1 + R_4 \cdot y_{44}} \qquad (5)$$

Once the data is obtained in step a), the response of the component 1 under any test configuration can be calculated. In particular, the response of the component 1 under several test configurations (e.g. under the nine configurations typically used for FRA) can be calculated easily and quickly.

3. General applications:

In the first embodiment above, the application of the present method for FRA measurements on a transformer 1 having seven terminals L1, L2, L3, N, H1, H2, H3 has been described. It must be noted, though, that the method can be used for numerous other applications. In particular:

Instead of using the method on a transformer 1, the component 1 under test may also be an electrical generator and/or an electrical motor.

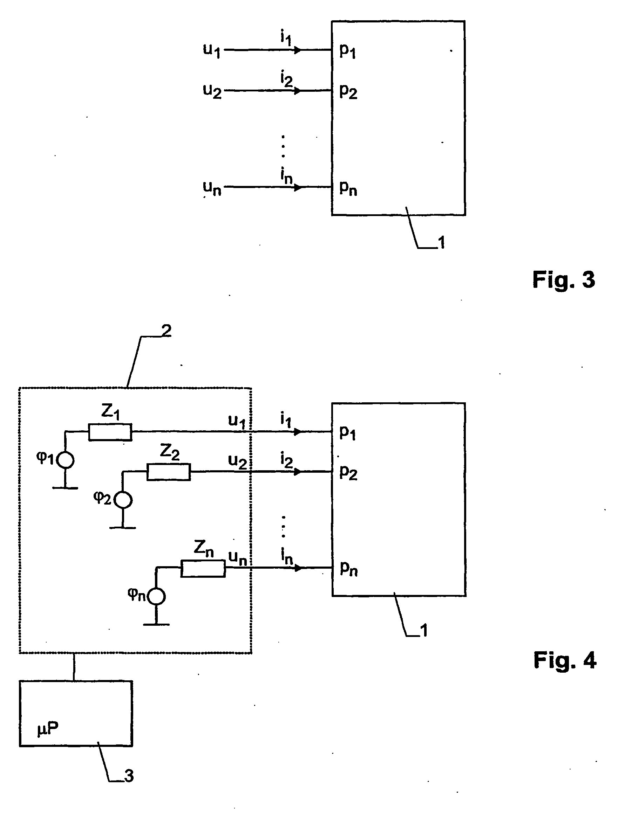

In general, the number n of terminals $p_1$, ..., $p_n$ (Fig. 3, 4) of the component 1 may vary, and e.g. be three (e.g. for a three-phase motor in delta configuration) or four (e.g. for a three phase generator in star configuration or for a one phase transformer). The present method is in particular useful for components 1 with more than two terminals $p_1$, ..., $p_n$, where there is a potentially large number of different terminal configurations

The present method can be used for various purposes. A typical application is quality control, e.g. by using FRA as described above, or by simulating other measurements using the data obtained in measurement step a). Another application is network modeling: Some network models require the measurement of the linear response of a component 1 under certain given terminal configurations - the present method can obviate the need to actually carry out these measurements by using the data from measurement step a) in order to calculate the response under the given terminal configurations.

4. Improved measurement method:

This section describes an improved method for obtaining the data in measurement step a).

Fig. 3 shows a multi-terminal component 1 having $n > 1$ terminals $p_1$ through $p_n$, which may be a transformer, electrical motor or generator. When linear voltages $u_1$ through $u_n$ are applied to the terminals $p_1$ through $p_n$, currents $i_1$ through $i_n$ will flow. The linear electrical response of component 1 is characterised by its admittance matrix Y or, equivalently, by its impedance matrix Z. In admittance notation, applying the voltage vector u = ($u_1$ ... $u_n$) of voltages at the terminals $p_1$ through $p_n$ generates a current vector **i** = ($i_1$ ... $i_n$) as follows:

$$\mathbf{i} = \mathbf{Y} \cdot \mathbf{u}. \qquad (11)$$

The general principle of the improved measurement method is based on an estimation procedure and a measurement procedure. In the estimation procedure, an estimated admittance matrix **Y'** is determined, in the measurement procedure a more accurate measurement is carried out.

In the estimation procedure, the elements of the estimated admittance matrix **Y'** can e.g. be measured directly using conventional methods. The diagonal elements $Y'_{ii}$ can e.g. by measured by applying a voltage $u_i$ to terminal $p_i$ and measuring the current $i_i$ at the same terminal $p_i$ while all other terminals are short-circuited to zero volt, i.e. $Y'_{ii} = i_i/u_i$ while $u_j = 0$ for $i \# j$. The other elements $Y'_{ij}$ of the matrix can be measured by applying a voltage $u_i$ at terminal $p_i$ while setting all other terminals to zero volt and measuring the current $ij$ at terminal $p_j$, $Y'_{ij} = i_j/u_i$ while $u_j = 0$ for $i \neq j$.

Other conventional methods for measuring the estimated impedance matrix Y' in the estimation procedure can be used as well.

In general, the estimated admittance matrix **Y'** has $n$ eigenvalues $\lambda_1 \dots \lambda_n$ and $n$ corresponding to (normalised) eigenvectors $v_1 \dots v_n$ for which

$$\mathbf{Y'} \cdot \mathbf{v}_k = \lambda_k \cdot \mathbf{v}_k. \qquad (12)$$

Once the estimated admittance matrix **Y'** is known, its eigenvectors $\mathbf{v}_k$ can be calculated.

In a measurement procedure following the estimation procedure, several (in general $n$) voltage patterns $\mathbf{u}_k = (u_{1k} \dots u_{nk})$ are applied to terminals $p_1 \dots p_n$ of component 1. Each voltage pattern $\mathbf{u}_k$ corresponds to one of the eigenvectors $\mathbf{v}_k$. For each applied voltage pattern $u_k$, a response of the component 1 is measured, in particular by measuring the induced current pattern $i_k$.

As mentioned above, voltage pattern $u_k$ corresponds to the (normalised) eigenvector $v_k$ (which is one of the $n$ normalised eigenvectors of the admittance matrix), namely in the sense that the voltage pattern $u_k$ is substantially parallel to the eigenvector $\mathbf{v}_k$ corresponding to eigenvalue $\lambda_k$. Theoretically, using $\mathbf{u}_k \propto \mathbf{v}_k$ would be the best solution, but a measuring device 2, 3 generating the voltage patterns $\mathbf{u}_k$ will, in general, not be able to generate voltage patterns matching the eigenvectors $\mathbf{v}_k$ exactly due to discretisation errors. Methods for handling devices 2, 3 with limited resolution for generating the voltage patterns will be addressed below.

Once the measurement procedure is complete, the voltage patterns $u_k$ and the corresponding current patterns $i_k$, i.e. a set of $n$ voltage and current vector pairs $u_k$, $i_k$, fully characterises the linear response of the component 1.

In general, the admittance matrix Y is frequency dependent. Hence, in many applications, the linear electrical response of component 1 should be known for an extended frequency range, e.g. from 50 Hz to more than 500 kHz. For this reason, the estimation procedure is carried out at a plurality of frequencies $\omega_i$ in the given frequency range.

Advantageously, for each estimation procedure, the eigenvalues $\lambda_k(\omega_i)$ at the given frequency $\omega_i$ are calculated. Then, the most critical frequencies are determined, which are those frequencies where the eigenvalues $\lambda_k(\omega_i)$ reach a local maximum or minimum or, in particular, where the absolute ratio between the largest and smallest eigenvalue has a maximum or exceeds a given threshold. These critical frequencies are of particular interest, either because they are indicative of a resonance of component 1 or because they show that some of the estimated eigenvalues may be of poor accuracy and the described measurement procedure is required to increase the accuracy.

It is principally possible to divide the desired frequency range into a number of frequency windows and to calculate the most critical frequencies in each frequency window.

For each or at least some of the critical frequencies, the measurement procedure described above is carried out to refine the measurement. In addition or alternatively thereto, the measurement procedure can be carried out at other points within the frequency range.of interest.

The frequencies $\omega_i$ where measurements are carried out can be distributed linearly or logarithmically over the range of frequencies of interest. In an advantageous embodiment, though, the density of measurement frequencies $\omega_i$ close to the critical frequencies as mentioned above is larger than the density of measurement frequencies $\omega_i$ in spectral regions far away from the critical frequencies. This allows to obtain a more reliable characterisation of the component 1.

4.1 The measuring device:

A general measuring device 2, 3 for carrying out the improved measurement method is disclosed in Fig. 4. In a most general case, measuring device 2, 3 comprises n adjustable voltage sources generating voltages $\varphi_1$ to $\varphi_n$, which are fed to the terminals $p_1$ to $p_n$ through impedances $Z_1$ to $Z_n$. The voltages $\varphi_1$ to $\varphi_n$ all have equal frequency and known phase relationship. The impedances $Z_1$ through $Z_n$ may be practically zero or, as described below, they may be adjustable and potentially non-zero. A control unit 3 is provided for automatically adjusting the voltage sources and, where applicable, the impedances $Z_1$ to $Z_n$.

For the device of Fig. 4 we have

$$\boldsymbol{\varphi} = \mathbf{u} + \mathbf{D} \cdot \mathbf{i}, \tag{13}$$

where $\varphi = (\varphi_1 \ldots \varphi_n)$ are the voltages of the voltage sources, $u = (u_1 \ldots u_n)$ the input voltages at the terminals $p_1, \text{.-}, p_n$, and $D$ is a diagonal matrix with the diagonal elements $Z_1$ to $Z_n$.

Combining equations (11) and (13) gives the following relationship between the input voltages u and the applied voltages $\varphi$:

$$\mathbf{u} = (\mathbf{I} + \mathbf{D} \cdot \mathbf{Y})^{-1} \cdot \boldsymbol{\varphi}. \tag{14}$$

where I is the $n \times n$ identity matrix.

As mentioned above, the applied voltages u should correspond to the eigenvalues $\mathbf{v}_k$ of the estimated admittance matrix **Y'**. In general, however, it will not be possible to match this condition exactly, because the voltage sources will not be able to generate any arbitrary voltage values, but only a discrete set of values. If the number of voltage values that can be generated is small, the impedances $Z_1$ to $Z_n$ can be designed to be adjustable as well in order to obtain a larger number of different input voltages u.

The input voltage vector $u_k$ can be expressed as a linear combination of the eigenvalues $v_i$, i.e.

$$\mathbf{u}_k = \sum_{i=1}^{n} \alpha_i \mathbf{v}_i \,. \tag{15}$$

with coefficients $\alpha_i$. Combining equations (15) , (11) and (12) yields

$$\mathbf{i} = \sum_{i=1}^{n} \lambda_i \alpha_i \mathbf{v}_i \,. \tag{5}$$

Hence, in order to maximise the influence of the k-th eigenvalue $\lambda_k$ on the input current vector **i** in proportion to the other eigenvalues, the following error function must be minimised

$$\frac{\sum\limits_{i=1}^{n} (\lambda_i \alpha_i)^2 - (\lambda_k \alpha_k)^2}{(\lambda_k \alpha_k)^2} \,. \tag{16}$$

In other words, for each eigenvalue $\lambda_k$, the coefficients $\alpha_1 \ldots \alpha_n$ must be found (among the set of possible coefficients, which is a finite set due to the discretisation inherent to measuring device 2) for which the term of equation (16) is smallest.

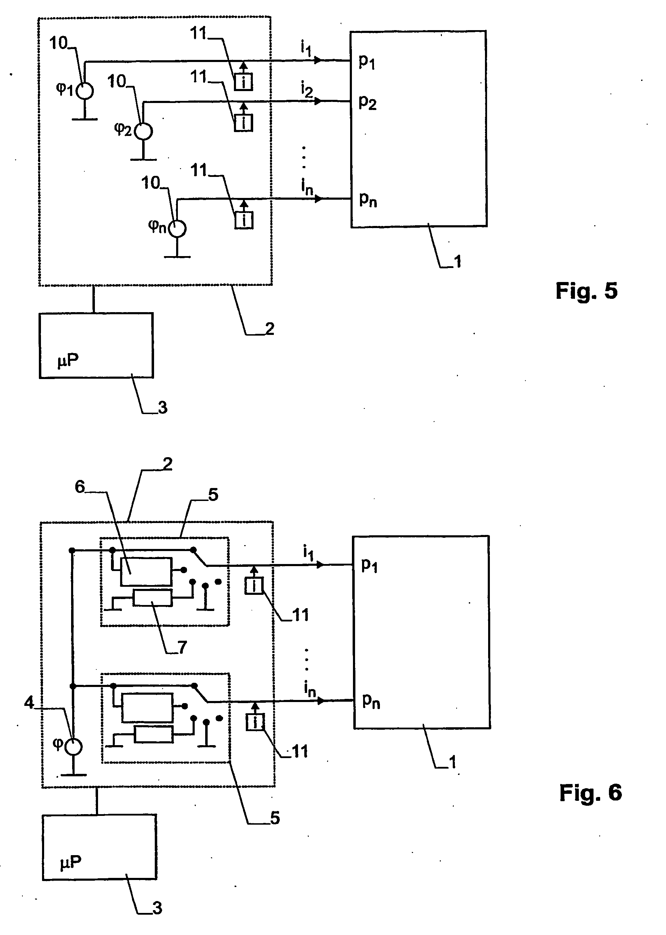

If measuring device 2 has adjustable voltage sources and impedances as shown in Fig. 5, we have

$$\boldsymbol{\alpha} = \begin{bmatrix} \mathbf{v}_1 & . & . & \mathbf{v}_n \end{bmatrix}^{-1} \cdot (\mathbf{I} + \mathbf{D} \cdot \mathbf{Y'})^{-1} \cdot \boldsymbol{\varphi} \tag{17}$$

A measuring device 2, 3 for carrying out the above method should, in general, comprise $n$ voltage generators 10 that are programmable to apply the voltage pattern u to the $n$ terminals of the component 1 undre test. Further, it should comprise $n$ current sensors 11 to measure the currents i. It should be adapted to apply at least $n$ suitable voltage patterns u to the terminals $p_1$, ..., $p_n$ consecutively for measuring the linear response of the component 1 automatically. This is especially advantageous for components 1 having more than two terminals $p_1$, ..., $p_n$, because using this kind of automatic measurement on components 1 with $n > 2$ terminals $p_1$, ..., $p_n$ provides substantial gains in speed and accuracy while reducing the costs.

Advantageously, the measuring device 2, 3 should comprise a control unit 3 for carrying out the measurement using the estimation and measurement procedures outlined above.

One possible embodiment of a measuring device 2, 3 is shown in Fig. 5. In this device 2, 3, a voltage generator 10 for generating an individual voltage $\varphi_i$ of adjustable amplitude and phase is provided for each input terminal $p_i$, ..., $p_n$. It also comprises $n$ current sensors 11, one for measuring the current to/from each terminal $p_1$, ..., $p_n$. Control unit 3 is able to set the applied input voltage u directly by controlling the voltage generators 10. If the number of voltage values that can be generated by each voltage generator 10 is small, an optimum voltage for a given eigenvector $\mathbf{v}_k$ can be calculated by minimising the term of equation (16). For each applied voltage pattern $u_k$, control unit 3 measures the currents i through the terminals $p_1$, ..., $p_n$ by means of the current sensors 11.

Another possible embodiment of a measuring device is shown in Fig. 6. This device comprises a single voltage source 4 only. The voltage $\varphi$ from the voltage source 4 is fed to $n$ voltage converters 5 controlled by control unit 3, the voltage source 4 and voltage converters 5 being used instead of the voltage generators 10 of the previous embodiment. Each voltage converter 5 selectively connects one terminal $p_1$, ..., $p_n$ to either the voltage $\varphi$ directly, to the voltage $\varphi$ through a damping circuitry 6, to ground via an impedance 7, to ground directly, or leaves the terminal $p_1$, ..., $p_n$ open (infinite impedance). This measuring circuit has the advantage that it requires a single voltage source 4 only. Suitable settings of the voltage converters for each value can be calculated form equations (16) and (17).

Further processing of the results:

As mentioned above, the described improved measurement procedure yields, for a given frequency, a set of voltage patterns $u_k$ and the corresponding current patterns $i_k$, which fully characterise the linear response of component 1 at the given frequency.

The values $u_k$ and $i_k$ for $k = 1 ... n$ can, in principle, be converted into a more accurate estimate of the admittance matrix Y or the corresponding impedance matrix Z. However, if the smallest and largest eigenvalues of admittance matrix Y differ by several orders of magnitude, such a matrix Y is difficult to process numerically with floating point calculations due to rounding errors and limited accuracy of the numerical algorithms. Hence, in an advantageous embodiment of the present invention, the vector pairs $u_k$ and $i_k$ are used directly for further processing, without prior conversion to an admittance matrix **Y** or impedance matrix **Z**.

For example, the results of the measurement procedure can e.g. be used for FRA as described above or for modeling the electrical properties the component 1 or of a network that component 1 is part of. Such a model can e.g. be used to analyse the stability of the network in general or its response to given events in particular.

List of reference numbers

**[0078]**

1    component under test
2    measuring device
3    control unit, part of measuring device
4    single voltage source
5    voltage converter
6    damping circuit
7    impedance
10   voltage generator
11   current sensor

**Claims**

**1.** A method for determining a linear electrical response of a component (1) under at least one test terminal configuration, wherein said component (1) is a transformer, generator or electrical motor comprising several terminals ($p_1$, ..., $p_n$), wherein a terminal configuration refers to a defined state of all terminals of the component (1), and wherein the state of a terminal ($p_k$) can be defined by

    - a current ($i_k$) that is flowing through it or

- a voltage ($u_k$) that is applied to it or
- an impedance ($Z_k$) and a voltage ($\varphi_k$) of a voltage source that are connected in series to it, or
- an index ($m$) of another terminal ($p_m$) that the given terminal ($p_k$) is connected to, or
- a series of indices ($m_1, m_2, ...,$ ) if the given terminal ($p_k$) is connected to several other terminals,

said method comprising the steps of

step a) applying a set of terminal configurations to said terminals ($p_l, ..., p_n$) and obtaining as a function of frequency data descriptive of the linear electrical response of said component (1) to any pattern of voltages or currents applied to the terminals ($p_1, ..., p_n$), wherein said data is descriptive of the linear electrical response of said component (1) over a frequency range between less than 100 Hz and more than 500 kHz, and wherein the set of terminal configurations does not comprise the test terminal configuration, and
step b) calculating the response under the test terminal configuration from said data.

2. The method of claim 1, wherein step b) comprises the calculation of the response of the component (1) under a plurality of different test terminal configurations.

3. The method of any of the preceding claims, wherein said step a) comprises the step of simultaneously connecting a multitude of the terminals ($p_1...., p_n$), in particular all of the terminals ($p_1, ..., p_n$), of said component (1) to a measuring device (2, 3), which is adapted to generate said set of terminal configurations, and to measure the response of said component (1) to said terminal configurations.

4. The method of claim 3, wherein said measuring device (2, 3) comprises, for each terminal ($p_1, ..., p_n$),
an adjustable voltage source (10; 4, 5), and/or
an adjustable current source, and/or
an adjustable impedance ($Z_1, ..., Z_n$) ,
wherein said set of terminal configurations is generated by adjusting said voltage sources (10; 4, 5), current sources and/or impedances ($Z_1, ..., Z_n$), respectively.

5. The method of any of the claims 3 or 4
wherein said voltage sources (10; 4, 5), current sources and/or impedances ($Z_1, ..., Z_n$) are adjusted automatically under control of said measuring device (2, 3).

6. The method of any of the preceding claims, wherein said step b) comprises the step of calculating a voltage ratio and/or voltage phase difference between two different terminals ($p_1, ..., p_n$).

7. The method of claim 6, wherein said step b) comprises the step of calculating a voltage ratio and/or voltage phase difference between two different terminals ($p_1, ..., p_n$) as a function of frequency.

8. The method of any of the preceding claims, wherein said component (1) has more than two terminals ($p_1, ..., P_n$).

9. The method of any of the preceding claims, wherein said component (1) is a high-voltage or medium-voltage device (1).

10. The method of any of the preceding claims, wherein said data comprises a set of $N$ linearly independent current and voltage vector pairs $\mathbf{i}_k$, $\mathbf{u}_k$, each pair describing the voltages and corresponding currents at said terminals ($p_1, ..., p_n$), wherein $N$ is the number of terminals ($p_1, ..., p_n$) being measured of said component (1).

11. The method of any of the preceding claims, wherein said step a) comprises
an estimation procedure comprising the step of determining an estimated admittance matrix $\mathbf{Y}'$ of said component (1) by applying voltages to said terminals ($p_1, ..., p_n$) and measuring a response of said component (1) and
a measurement procedure comprising the step of applying several voltage patterns $\mathbf{u}_k$ to the terminals ($p_1, ..., p_n$) of said component (1), each voltage pattern $\mathbf{u}_k$ corresponding to an eigenvector $\mathbf{v}_k$ of said estimated admittance matrix $\mathbf{Y}'$, and determining, for each applied voltage pattern $u_k$, a response of said component (1).

12. The method of claim 11 wherein said voltage patterns $\mathbf{u}_k$ are generated by means of a measuring device (2, 3) capable of applying a discrete set of different voltage patterns $\mathbf{u}_k$ to said terminal ($p_1, ..., p_n$), wherein each voltage pattern $\mathbf{u}_k$ corresponds to that member of said set that has the property that the term

$$\frac{\sum\limits_{i=1}^{n}(\lambda_i\alpha_i)^2 - (\lambda_k\alpha_k)^2}{(\lambda_k\alpha_k)^2}$$

is minimal, wherein $\lambda_1, ..., \lambda_n$ are n eigenvalues of the estimated admittance matrix **Y'** and

$$\mathbf{u}_k = \sum_{i=1}^{n}\alpha_i\mathbf{v}_i$$

with coefficients $\alpha_i$.

13. A use of the method of any of the preceding claims for characterising said component (1) by the steps of
providing a reference describing a first response of said component (1) at said test terminal configuration,
using said step a) to measure an actual state of said component (1), and
using said step b) to calculate a second response at said test terminal configuration, and
comparing said first and said second response.

14. The use of claim 13, wherein said reference was derived from a measurement carried out prior to said step a).

**Patentansprüche**

1. Verfahren zum Bestimmen eines linearen elektrischen Ansprechverhaltens einer Komponente (1) unter mindestens einer Prüfanschlusskonfiguration,
wobei die Komponente (1) ein Transformator, Generator oder Elektromotor mit mehreren Anschlüssen ($p_1, ..., p_n$) ist,
wobei sich eine Anschlusskonfiguration auf einen definierten Zustand aller Anschlüsse der Komponente (1) bezieht und
wobei der Zustand eines Anschlusses ($p_k$) durch Folgendes definiert werden kann:

   - einen Strom ($i_k$), der durch ihn fließt, oder
   - eine Spannung ($u_k$), die an ihn angelegt ist, oder
   - eine Impedanz ($Z_k$) und eine Spannung ($\varphi_k$) einer Spannungsquelle, die mit ihm in Reihe geschaltet sind, oder
   - einen Index ($m$) eines anderen Anschlusses ($p_m$), mit dem der gegebene Anschluss ($p_k$) verbunden ist, oder
   - eine Reihe von Indizes ($m_1, m_2, ...,$), wenn der gegebene Anschluss ($p_k$) mit mehreren anderen Anschlüssen verbunden ist,

   wobei das Verfahren die folgenden Schritte umfasst:

   Schritt a) Anwenden einer Menge von Anschlusskonfigurationen auf die Anschlüsse ($p_1, ..., p_n$) und Erhalten von Daten als Funktion der Frequenz, die das lineare elektrische Ansprechverhalten der Komponente (1) auf ein beliebiges Muster von an die Anschlüsse ($p_1, ..., p_n$) angelegten Spannungen oder Strömen beschreiben, wobei die Daten das lineare elektrische Ansprechverhalten der Komponente (1) über einen Frequenzbereich zwischen weniger als 100 Hz und mehr als 500 kHz beschreiben und wobei die Menge von Anschlusskonfigurationen die Prüfanschlusskonfiguration nicht umfasst und
   Schritt b) Berechnen des Ansprechverhaltens unter der Prüfanschlusskonfiguration aus den Daten.

2. Verfahren nach Anspruch 1, wobei Schritt b) die Berechnung des Ansprechverhaltens der Komponente (1) unter mehreren verschiedenen Prüfanschlusskonfigurationen umfasst.

3. Verfahren nach einem der vorhergehenden Ansprüche, wobei Schritt a) den Schritt des gleichzeitigen Verbindens einer Vielzahl der Anschlüsse ($p_1 ..., p_n$), insbesondere aller Anschlüsse ($p_1, ..., p_n$), der Komponente (1) mit einer Messeinrichtung (2, 3) umfasst, die dafür ausgelegt ist, die Menge von Anschlusskonfigurationen zu erzeugen und das Ansprechverhalten der Komponente (1) auf die Anschlusskonfigurationen zu messen.

4. Verfahren nach Anspruch 3, wobei die Messeinrichtung (2, 3) für jeden Anschluss ($p_1$, ..., $p_n$) Folgendes umfasst:

   eine einstellbare Spannungsquelle (10; 4, 5) und/oder
   eine einstellbare Stromquelle und/oder
   eine einstellbare Impedanz ($Z_1$, ..., $Z_n$) ,

   wobei die Menge von Anschlusskonfigurationen jeweils durch Einstellen der Spannungsquellen (10; 4, 5), der Stromquellen und/oder Impedanzen ($Z_1$, ..., $Z_n$) erzeugt wird.

5. Verfahren nach einem der Ansprüche 3 oder 4, wobei die Spannungsquellen (10; 4, 5), die Stromquellen und/oder Impedanzen ($Z_1$, ..., $Z_n$) automatisch unter der Kontrolle der Messeinrichtung (2, 3) eingestellt werden.

6. Verfahren nach einem der vorhergehenden Ansprüche, wobei Schritt b) den Schritt des Berechnens eines Spannungsverhältnisses und/oder einer Spannungsphasendifferenz zwischen zwei verschiedenen Anschlüssen ($p_1$, ..., $p_n$) umfasst.

7. Verfahren nach Anspruch 6, wobei Schritt b) den Schritt des Berechnens eines Spannungsverhältnisses und/oder einer Spannungsphasendifferenz zwischen zwei verschiedenen Anschlüssen ($p_1$, ..., $p_n$) als Funktion der Frequenz umfasst.

8. Verfahren nach einem der vorhergehenden Ansprüche, wobei die Komponente (1) mehr als zwei Anschlüsse ($p_1$, ..., $p_n$) aufweist.

9. Verfahren nach einem der vorhergehenden Ansprüche, wobei die Komponente (1) eine Hochspannungs- oder Mittelspannungseinrichtung (1) ist.

10. Verfahren nach einem der vorhergehenden Ansprüche, wobei die Daten eine Menge von $N$ linear unabhängigen Strom- und Spannungsvektorpaaren $i_k$, $u_k$ umfassen, wobei jedes Paar die Spannungen und entsprechenden Ströme an den Anschlüssen ($p_1$, ..., $p_n$) beschreibt, wobei $N$ die Anzahl der Anschlüsse ($p_1$, ..., $p_n$) ist, die von der Komponente (1) gemessen werden.

11. Verfahren nach einem der vorhergehenden Ansprüche, wobei Schritt a) Folgendes umfasst:

    eine Schätzungsprozedur mit dem Schritt des Bestimmens einer geschätzten Admittanzmatrix **Y'** der Komponente (1) durch Anlegen von Spannungen an die Anschlüsse ($p_1$, ..., $p_n$) und Messen eines Ansprechverhaltens der Komponente (1) und
    eine Messprozedur mit dem Schritt des Anlegens von mehreren Spannungsmustern $u_k$ an die Anschlüsse ($p_1$, ..., $p_n$) der Komponente (1), wobei jedes Spannungsmuster $u_k$ einem Eigenvektor $v_k$ der geschätzten Admittanzmatrix **Y'** entspricht, und des Bestimmens eines Ansprechverhaltens der Komponente (1) für jedes angelegte Spannungsmuster $u_k$.

12. Verfahren nach Anspruch 11, wobei die Spannungsmuster $u_k$ mittels einer Messeinrichtung (2, 3) erzeugt werden, die in der Lage ist, eine diskrete Menge verschiedener Spannungsmuster $u_k$ an den Anschluss ($p_1$, ..., $p_n$) anzulegen, wobei jedes Spannungsmuster $u_k$ demjenigen Element der Menge entspricht, das die Eigenschaft aufweist, dass der Term

$$\frac{\sum_{i=1}^{n} (\lambda_i \alpha_i)^2 - (\lambda_k \alpha_k)^2}{(\lambda_k \alpha_k)^2}$$

minimal ist, wobei $\lambda_1$, ..., $\lambda_n$ n Eigenwerte der geschätzten Admittanzmatrix **Y'** sind, und

$$\mathbf{u}_k = \sum_{i=1}^{n} \alpha_i \mathbf{v}_i$$

mit Koeffizienten $\alpha_i$ ist.

**13.** Gebrauch des Verfahrens nach einem der vorhergehenden Ansprüche zum Charakterisieren der Komponente (1) durch die folgenden Schritte:

Bereitstellen einer Referenz, die ein erstes Ansprechverhalten der Komponente (1) an der Prüfanschlusskonfiguration beschreibt,
Verwenden von Schritt a) zur Messung eines tatsächlichen Zustands der Komponente (1) und
Verwenden von Schritt b) zur Berechnung eines zweiten Ansprechverhaltens bei der Prüfanschlusskonfiguration und
Vergleichen des ersten und zweiten Ansprechverhaltens.

**14.** Gebrauch nach Anspruch 13, wobei die Referenz aus einer vor Schritt a) ausgeführten Messung abgeleitet wurde.

**Revendications**

**1.** Procédé permettant de déterminer une réponse électrique linéaire d'un composant (1) dans au moins une configuration de bornes de test,
dans lequel ledit composant (1) est un transformateur, un générateur ou un moteur électrique comprenant plusieurs bornes ($p_1$, ... , $p_n$) ,
dans lequel une configuration de bornes a pour référence un état défini de toutes les bornes du composant (1), et
dans lequel l'état d'une borne ($p_k$) peut être défini par

- un courant ($i_k$) qui passe dans celle-ci ou
- une tension ($u_k$) qui lui est appliquée ou
- une impédance ($Z_k$) et une tension ($\varphi_k$) d'une source de tension qui lui sont connectées en série ou
- un indice (*m*) d'une autre borne ($p_m$) à laquelle est connectée la borne donnée ($p_k$) ou
- une série d'indices (*$m_1$, $m_2$, ...*) si la borne donnée ($p_k$) est connectée à plusieurs autres bornes,

ledit procédé comprenant les étapes suivante

une étape a) consistant à appliquer un ensemble de configurations de bornes auxdites bornes ($p_1$, ..., $p_n$) et à obtenir en tant que fonction de la fréquence des données représentatives de la réponse électrique linéaire dudit composant (1) à un motif quelconque de tensions ou de courants appliqués aux bornes ($p_1$, ..., $p_n$), dans lequel lesdites données sont représentatives de la réponse électrique linéaire dudit composant (1) dans une gamme de fréquences comprise entre moins de 100 Hz et plus de 500 kHz, et dans lequel l'ensemble de configurations de bornes ne comprend pas la configuration de bornes de test, et
une étape b) consistant à calculer la réponse dans la configuration de bornes de test obtenue à partir desdites données.

**2.** Procédé selon la revendication 1, dans lequel l'étape b) comprend le calcul de la réponse du composant (1) soumis à une pluralité de configurations de bornes de test différentes.

**3.** Procédé selon l'une quelconque des revendications précédentes, dans lequel l'étape a) comprend l'étape consistant à connecter simultanément une multitude de bornes ($p_1$, ..., $p_n$), notamment la totalité des bornes ($p_1$, ..., $p_n$) , dudit composant (1) à un dispositif de mesure (2, 3) qui est apte à générer ledit ensemble de configurations de bornes, et à mesurer la réponse dudit composant (1) auxdites configurations de bornes.

**4.** Procédé selon la revendication 3, dans lequel ledit dispositif de mesure (2, 3) comprend, pour chaque borne ($p_1$, ..., $p_n$) ,
une source de tension réglable (10 ; 4, 5), et/ou une source de courant réglable, et/ou

une impédance réglable (Z$_1$, ..., Z$_n$),
dans lequel ledit ensemble de configurations de bornes est généré en ajustant respectivement lesdites sources de tension (10 ; 4, 5), lesdites sources de courant et/ou lesdites impédances (Z$_1$, ..., Z$_n$).

5. Procédé selon l'une quelconque des revendications 3 ou 4, dans lequel lesdites sources de tension (10 ; 4, 5), lesdites sources de courant et/ou lesdites impédances (Z$_1$, ..., Z$_n$) sont automatiquement ajustées sous le contrôle dudit dispositif de mesure (2, 3).

6. Procédé selon l'une quelconque des revendications précédentes, dans lequel ladite étape b) comprend l'étape consistant à calculer un rapport de tensions et/ou une différence de phase de tension entre deux bornes différentes (p$_1$, ... , p$_n$).

7. Procédé selon la revendication 6, dans lequel ladite étape b) comprend l'étape consistant à calculer un rapport de tensions et/ou une différence de phase de tension entre deux bornes différentes (p$_1$, ..., p$_n$) en fonction de la fréquence.

8. Procédé selon l'une quelconque des revendications précédentes, dans lequel ledit composant (1) comporte plus de deux bornes (p$_1$, ..., p$_n$).

9. Procédé selon l'une quelconque des revendications précédentes, dans lequel ledit composant (1) est un dispositif à haute tension ou à tension moyenne (1).

10. Procédé selon l'une quelconque des revendications précédentes, dans lequel lesdites données comprennent un ensemble de N paires de vecteurs de courant et de tension linéairement indépendants i$_k$, u$_k$, chaque paire décrivant les tensions et des courants correspondants sur lesdites bornes (p$_1$, ..., p$_n$), où N est le nombre de bornes (p$_1$, ..., p$_n$) mesurées dudit composant (1).

11. Procédé selon l'une quelconque des revendications précédentes, dans lequel ladite étape a) comprend :

une procédure d'estimation comprenant l'étape consistant à déterminer une matrice d'admittance estimée **Y'** dudit composant (1) en appliquant des tensions auxdites bornes (p$_1$, ..., p$_n$) et en mesurant une réponse dudit composant (1) et
une procédure de mesure comprenant l'étape consistant à appliquer plusieurs motifs de tension **u**$_k$ aux bornes (p$_1$, ..., p$_n$) dudit composant (1), chaque motif de tension **u**$_k$ correspondant à un vecteur propre **v**$_k$ de ladite matrice d'admittance estimée **Y'**, et à déterminer, pour chaque motif de tension appliqué **u**$_k$, une réponse dudit composant (1).

12. Procédé selon la revendication 11, dans lequel lesdits motifs de tension **u**$_k$ sont générés au moyen d'un dispositif de mesure (2, 3) capable d'appliquer un ensemble discret de différents motifs de tension **u**$_k$ à ladite borne (p$_1$, ..., p$_n$) , dans lequel chaque motif de tension **u**$_k$ correspond à l'élément dudit ensemble ayant pour propriété que le terme

$$\frac{\sum_{i=1}^{n}(\lambda_i\alpha_i)^2 - (\lambda_k\alpha_k)^2}{(\lambda_k\alpha_k)^2}$$

est minimal, où $\lambda_1$, ... $\lambda_n$ sont n valeurs propres de la matrice d'admittance estimée **Y**' et

$$u_k = \sum_{i=1}^{n}\alpha_i v_i$$

avec pour coefficients $\alpha_i$.

13. Utilisation du procédé selon l'une quelconque des revendications précédentes pour caractériser ledit composant (1) par les étapes consistant à :

fournir une référence décrivant une première réponse dudit composant (1) à ladite configuration de bornes de test,
utiliser ladite étape a) pour mesurer un état réel dudit composant (1), et
utiliser ladite étape b) pour calculer une seconde réponse sur ladite configuration de bornes de test, et comparer lesdites première et seconde réponses.

14. Utilisation selon la revendication 13, dans laquelle ladite référence a été déterminée à partir d'une mesure effectuée avant ladite étape a).

L1

L2

L3

N

H1

H2

H3

**Fig. 1**

1

1

2

**Fig. 2**

16

**Fig. 3**

**Fig. 4**

Fig. 5

Fig. 6

## EP 2 024 755 B1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4156842 A
- GB 2411733 A

**Non-patent literature cited in the description**

- *IEEE Transcactions on Energhy Conversion,* September 1994, vol. 9 (3), 593ff